Europäisches Patentamt

European Patent Office

Office européen des brevets

(11) Publication number: **0 230 927 B1**

## EUROPEAN PATENT SPECIFICATION

(45) Date of publication of patent specification: **06.03.91**

(51) Int. Cl.5: **C30B 25/02**, C30B 29/04

(21) Application number: **87100527.8**

(22) Date of filing: **16.01.87**

(54) Diamond manufacturing.

(30) Priority: **17.01.86 JP 8458/86**
**17.01.86 JP 8459/86**

(43) Date of publication of application:
**05.08.87 Bulletin 87/32**

(45) Publication of the grant of the patent:
**06.03.91 Bulletin 91/10**

(84) Designated Contracting States:
**DE FR GB SE**

(56) References cited:
**EP-A- 0 161 829**

**PATENT ABSTRACTS OF JAPAN, vol. 9, no. 271 (C-311)[1994], 29th October 1985; & JP-A-60 118 694**

**PATENT ABSTRACTS OF JAPAN, vol. 9, no. 278 (C-312)[2001], 6th November 1985; & JP-A-60 122 794**

(73) Proprietor: **SUMITOMO ELECTRIC INDUSTRIES LIMITED**
**No. 15, Kitahama 5-chome, Higashi-ku Osaka-shi, Osaka 541(JP)**

(72) Inventor: **Ikegaya, Akihiko Itami Wks Sumitomo El. Ind. Ltd.**
**1-1, Koyakita 1-chome Itami-shi Hyogo(JP)**
Inventor: **Tobioka, Masaaki Itami Wks Sumitomo El. Ind. Ltd.**
**1-1, Koyakita 1-chome Itami-shi Hyogo(JP)**
Inventor: **Nomura, Toshio Itami Wks Sumitomo El. Ind. Ltd.**
**1-1, Koyakita 1-chome Itami-shi Hyogo(JP)**

(74) Representative: **Patentanwälte Grünecker, Kinkeldey, Stockmair & Partner Maximilianstrasse 58 W-8000 München 22(DE)**

## Description

### BACKGROUND OF THE INVENTION

This invention relates to a low-pressure gas-phase diamond synthesizing process. This process is used for synthesizing nearly perfected crystalline diamond films structurally containing only allotrope of carbon on a mass-production basis and an industrial scale. Conventional diamond synthesis carried out at high temperatures under high pressure is costly. This invention relates to low-pressure gas-phase diamond synthesis.

The following are known gas-phase diamond synthesizing processes: (1) high-frequency plasma CVD method and microwave plasma CVD method utilizing plasma; (2) ionization deposition method and ion beam deposition method utilizing ion particles; and (3) thermal radiation CVD method utilizing neutral particles.

A crystalline diamond film can be synthesized using methods (1) and (3), whereas a non-crystalline diamond-like carbon film can be synthesized using method (2). Since a crystalline diamond film is extremely hard and useful, attempts are being made to apply such a film to the surface coating of parts that need to be wear resistant, such as, for example, cutting tools. The use of a crystalline diamond film is also useful in the manufacture of semiconductor devices. Its high thermal conductivity makes it useful for heat sink elements and its large band gap energy permits impurities to be added to it for making useful semiconductor materials.

A diamond film synthesized according with the high-frequency plasma CVD or microwave plasma CVD method utilizing plasma, i.e. method (1), as compared with a diamond film synthesized using the thermal CVD method, contains a very small amount of carbon having structure other than that of diamond and is roughly free from defects such as a twin. Consequently, it is possible to synthesize diamond excellent in crystallizability, with its diamond film having good physical parameters, e.g., electrical resistance and hardness, which are closer to those of monocrystalline diamond containing almost nearly no impurities. The diamond film quality is better than that obtainable using the thermal CVD method. However, the method of activating the material gas by decomposing and exciting it using low-temperature plasma through electrical energy is disadvantageous because the contour of a substrate affects properties peculiar to discharge plasma and differentiates its discharge state, thus causing the plasma to be unevenly distributed. When the substrate has a sharp edge, for example, a strong discharge is initiated at the front end thereof. The plasma is distributed unevenly which makes obtaining a uniform coating difficult. This is also the case when the substrate has a complicated contour or ruggedness. The plasma is distributed unevenly, making it impossible to obtain a uniform coating.

In the synthesizing method using only the discharge plasma to activate the material gas, a high intensity of plasma is required. To make available a plasma having such a high energy density, use can be made of the microwave CVD equipment in which a reaction tube is vertically passed through a waveguide generally in use so as to cause microwave plasma to be formed in the reaction container inside the waveguide or the RF plasma CVD equipment for causing the plasma to be formed by loading a high-power radio frequency to provide inductive coupling type feeding. The zone wherein diamond can be synthesized using such an equipment is rather narrow. When it is attempted to increase each size and mass-produce diamond on an industrial scale, the size limitation becomes an obstacle to such attempts.

Using the ionization deposition and ion beam deposition methods utilizing ion particles, i.e. method (2), structurally non-crystalline diamond-form carbon tends to be produced and this makes it practically impossible to obtain diamond having excellent crystallization.

In the thermal CVD method, i.e. method (3), since no plasma is employed, diamond deposition is unaffected by the contour of the substrate. However, the quality of the diamond film synthesized thereby is inferior to what is synthesized using method (1), particularly the microwave plasma CVD method. This method has another disadvantage in that the reaction zone where diamond is caused to be deposited is narrow because the life of the reactive gas decomposed, excited and kept active is short.

Since the reactive gas must reach the substrate while it is activated to cause diamond to be deposited, the distance between the thermal electron radiating material and the substrate is necessarily limited because the life of the reactive gas in the activated state is short.

Such a narrow reaction zone has made difficult the application of the above methods to large scale industrial production. As set forth above, the reaction zone cannot be enlarged in accordance with any of the above diamond coating processes because of their inherent shortcomings. Therefore, a new method is required to provide a diamond film whose quality is equivalent to or higher than that of what is obtainable through the microwave plasma CVD method and to coat such a film uniformly on a substrate having a complicated sharp-edged contour. It is furthermore desirable to apply such a process to processing large numbers of subsrates simultaneously.

It is the object of the present invention to provide a new, low pressure gas-phase diamond synthesizing process, which is improved with respect to the above-mentioned requirements.

The process according to the present invention comprises the steps of:

heating a substrate disposed in a reaction container to higher than 600°C and lower than 1,200°C;

activating a mixed gas of hydrogen and hydrocarbon using a thermal electron radiating material heated to higher than 1,600°C, in which gas the percentage of the number of carbon atoms contained in the hydrocarbon in terms of $N_2$ is more than 0.01 and less than 20 and in which reaction container the pressure is $0.133 \times 10^2$ Pa to $133 \times 10^2$ Pa (0.1 to 100 Torr.);

forming high-frequency plasma by providing capacitive coupling-type feeding to the thermal electron radiating material using a high-frequency power supply so as to employ activation implemented by the thermal electon radiating material and that which is effected by the formation of the high-frequency plasma; and

depositing diamond on surfaces of said substrate;
wherein

the step of forming a high frequency plasma comprises

the step of forming a plasma by providing capacitive coupling-type feeding between said thermal electron radiating material and an electrode within said reaction container, or

the step of forming a plasma by providing capacitive coupling-type feeding between said thermal electron radiating material and said reaction container which is conductive, or

the step of forming a plasma by providing capacitive coupling-type feeding between said thermal electron radiating material and an electrode external to said reaction container.

The present invention provides a new process for coating a substrate uniformly even though it is large-sized or has a complicated, sharp-edged contour over a wide range of coating zone, or a large number of substrates. The inventive process provides a diamond film quality equivalent to or higher than that obtainable under the microwave plasma CVD method as one of the existing means. The inventors have discovered that using a low pressure gas-phase diamond synthesizing process in which a mixed gas of hydrogen and hydrogen carbon is activated and diamond is deposited on the surface of substrates heated to a temperature greater than 600° C and lower than 1,200° C, it is possible to coat the substrate uniformly even though it may be large and even though it may have complicated, sharp-edged contours. Coating can be obtained over a wide coating zone and a large number of substrates can be coated with excellent adhesion.

In a preferred embodiment of the invention, the process comprises the step of rotating said substrate during deposition of the diamond material. Furthermore, the substrate can be provided with a d.c. bias using a d.c. power supply and a high-frequency cut-off filter inserted between the high-frequency and the d. c. power supply, wherein the d.c. potential provided to the substrate is less than 1,000 V.

BRIEF DESCRIPTION OF THE DRAWINGS

Figs. 1a and 1b are top and elevational views, respectively of a first embodiment of an apparatus according to the present invention.

Figs. 2a and 2b are top and elevational views, respectively of a second embodiment of an apparatus according to the present invention.

Figs. 3a and 3b are top and elevational views, respectively of a third embodiment of an apparatus according to the present invention.

The methods according to the present invention are carried out using the apparatus shown in the various figures.

DETAILED DESCRIPTION OF THE PREFERRED EMBODIMENT

According to the invention, a diamond film can be obtained that contains almost no carbon other than that of diamond. It is substantially defect-free and scarcely has defects such as a twin. It also has excellent crystallization over a wide range reaction zone, which is attributable to the fact that the activation of the reaction gas is promoted by the decomposition and excitation thereof. The percentage of gas in the activated state is increased, whereby the life thereof is prolonged. The deposition of graphite and amorphous carbon, for instance, which are considered structurally different from diamond because of the presence of a large amount of atomic hydrogen is suppressed.

A high-frequency discharge plasma used for activating the material gas is formed by using a thermal electron radiating material and a capacitive coupling type feeding. Using capacitive coupling type feeding, compared with the inductive coupling, plasma can be formed stably in an extremely wide space, so that a wide range coating zone is obtained. However, a pressure ranging from several 10 Torr (13.3 x 10²Pa) up to 100 (133x10²Pa) Torr is insufficient to initiate and maintain discharge to provide the capacitive coupling type feeding and generate the high-frequency discharge plasma over a wide space. Therefore, thermal electron radiating material is used to radiate thermal electrons to make to initiate and maintain discharge under such high pressure and generate the plasma. The use of the thermal electron radiating material as one of the electrodes for applying a high-frequency load renders the current caused to flow into the electrode entirely different depending on the application of a half oycle of the high-frequency negative or positive potential. The intensity of the plasma varies at minute intervals, i.e., forms an intermittent plasma. Although the underlying principles of the intermittent plasma are not fully understood, it may be that the intermittent plasma suppresses graphite deposition and amorphous carbon deposition so that a diamond film of good quality is obtained. Since activation of the material gas is carried out simultaneously by the thermal electron radiating material and the high-frequency discharge plasma, the intensity of plasma can be lowered to the extent of the use of the thermal electron radiating material as compared with the microwave plasma CVD and RF plasma CVD methods employing only the formation of discharge plasma for the activation of the material gas. When a strong plasma is generated, the plasma is unevenly applied to the surface of the substrate depending on the contour thereof. But the simultaneous use of both the methods of activation reduces the otherwise uneven application of plasma and makes it possible to uniformly coat a substrate having a complicated, sharp-edged contour. The substrate may be electrically connected to one of the two electrodes for loading it with a high frequency or insulated therefrom.

The simultaneous use of the thermal electron radiating material and the high-frequency discharge plasma for activating the material gas can uniformly coat a large-sized substrate having a complicated, sharp-edged contour with a diamond film offering excellent film quality. By providing the substrate with a d.c. bias using a d.c. power supply, adhesion between the diamond film and the substrate is surprisingly improved.

Although the reason for the improvement in adhesion between the diamond film and the substrate because of the d.c. bias for the substrate is not fully understood, the high-frequency discharge plasma seems to cause the material gas to be ionized and its ions to be attracted to the surface of the substrate.

When the high-frequency together with the d.c. power supply for providing the workpiece with the d.c. potential is simultaneously used, a high-frequency cut-off filter should be inserted therebetween to prevent the high frequency from flowing into the d.c. power supply.

Various kinds of hydrocarbons can be used as the material. Just to name a few examples, one could use paraffine hydrocarbon such as ethane, methane, propane; olefin hydrocarbon; acetylene hydrocarbon; diolefin hydrocarbon; and other aromatic hydrocarbons.

The percentage of the number of carbon atoms contained in the hydrocarbon in terms of H2 should be more than 0.01 and less than 20. The rate of diamond growth is extremely small if the percentage is less than 0.01 and is not practical. Carbon having a structure other than that of diamond will be deposited if the percentage exceeds 20, thereby a diamond film is not formed. With respect to the gas to be introduced into the reaction container, thermally low-conductive Ar, Kr, Xe, Rn or N₂ other than the mixed gas of hydrogen and hydrocarbon and which does not participate in the reaction may be mixed therewith as a cooling gas. The thermal electron radiating material should have excellent thermal electron radiating capability, a low vapor pressure and a high melt point.

Accordingly, high melting point metals such as W, Ta and Mo, and LaB₆ and graphite should preferably be used. The thermal electron radiating material is heated to higher than 1,600° C. If it is not sufficiently heated, the deposition of graphite and amorphous carbon becomes dominant. No diamond is deposited unless the surface temperature of the substrate is greater than 600° C and lower than 1,200° C. The pressure in the reaction container should be at higher than (0.1 Torr) 0.133 x 10² Pa and lower than (100 Torr) 133 x10² Pa. If the pressure is outside the above range, diamond is not deposited.

The output of the high-frequency power supply applicable to the space where plasma is generated should preferably be higher than 0.01 W/cm³ and lower than 1.0 W/cm³ power flux density. The intensity of plasma developed using the CVD method is affected by the gas atmosphere, the discharge type, and the shape and structure of the discharge electrode. The intensity of plasma may be regulated conveniently by the output of the exciting power supply because the output thereof can readily be varied to change the intensity thereof over a wide range. Since the intensity of plasma is variable depending on the apparatus even when the same output is applied if the shape and structure of the discharge electrode are different, the intensity of plasma should preferably be represented by the power applied by the exciting power supply per unit volume of the space where the plasma is formed. If the power flux density is lower than 0.01 W/cm³, the effect of the improvement in the quality of the coating film by the simultaneous use of the high-frequency plasma according to the present invention will decrease. If the density is higher than 1.0 $W/cm^3$ the coating process will be badly affected and not preferred from an industrial standpoint because of the ion sputtering phenomenon and a power supply capable of providing the necessary power flux density is expensive. Moreover, the absolute value of the d.c. potential provided to the substrate should be less than 1,000 V. If the absolute value of the d.c. potential is higher than 1,000 V, the discharge will be unstable because an abnormal discharge occurs locally.

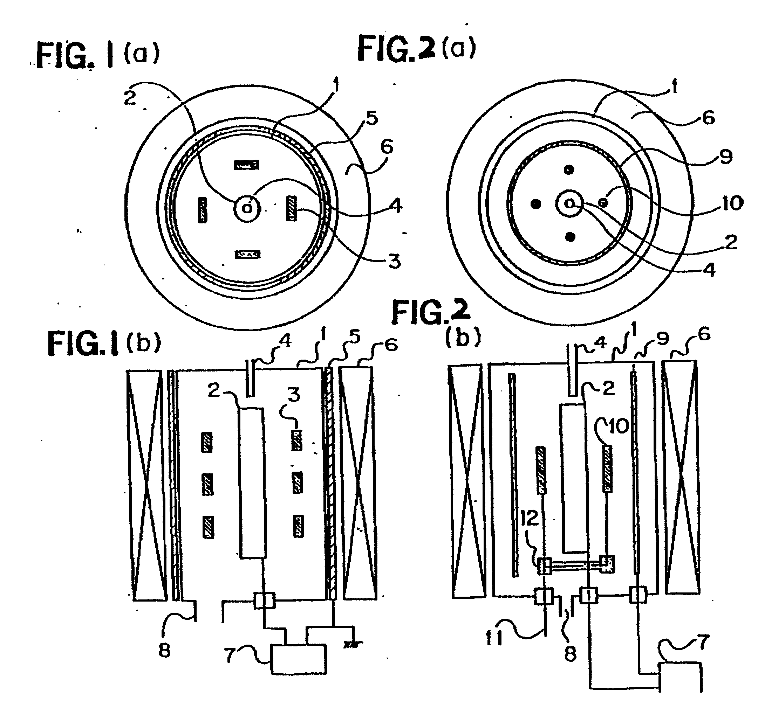

Figs. 1 (1a and 1b) and 2 (2a and 2b) show preferred embodiments of an apparatus in accordance with the present invention, wherein (a) and (b) are top and elevational views, respectively. In Figs 1a and 1b, there is shown an insulated reaction container and a cylindrical electrode 5 fitted on the outer periphery thereof, capacitive coupling type high-frequency feeding being provided to generate plasma between an electrode 5 and an internal thermal electron radiating material 2 driven by a power supply 7. In the Fig. 2a and 2b embodiment, high-frequency plasma is generated between a cylindrical electrode 9 inside the reaction container and thermal electron radiating material 2.

A shaft 11 is rotated by means of external motive power, which causes substrate 10 to rotate and revolve through a substrate rotating mechanism 12. The deposition of a diamond film is excellent since high-frequency plasma is generated over a wide range by providing capacitive coupling type feeding in addition to the activation of material gas by the thermal electron radiating material. However, the deposition thereof on one side directed the thermal electron radiating material is not equal to that on the opposite side. In the case of a substrate such as a drill, the workpiece is caused to rotate and revolve to ensure that it is uniformly coated with diamond.

The surfaces of the substrates 3, 10 are heated to higher than 600 °C but lower than 1,200 °C by the thermal electron radiating material heated to over 1,600 °C, an external heater 6 and the ion bombardment effect by high-frequency plasma. Air inside reaction container 1 is exhausted via an exhaust port 8 fitted to reaction container 1 and, vacuumized by a vacuumizer and the pressure is kept at higher than (0.1 Torr) $0.133 \times 10^2 Pa$ and lower than 100 Torr $133 \times 10^2 Pa$.

A mixed gas of hydrogen and hydrocarbon is supplied to thermal electron radiating material 2 through a material gas supply port 4. The gas is decomposed and excited by the high-frequency plasma generated by thermal electron radiating material 2 and between thermal electron radiating material 2 and reaction container 1 or electrode 5 outside the reaction container or electrode 9 inside the reaction container. The mixed gas is maintained in the activated state, whereby diamond is deposited on the surfaces of the substrates.

The following working examples are provided to more clearly describe the invention.

Example 1

Substrates prepared from ISO K-10 extra-hard alloy No. SPG 422, available on the open market, were coated with diamond using the apparatus of Figs. 1a and 1b.

The interior of the reaction container was first vacuumized to lower than ($10^{-3}$ Torr) 0.133Pa and a mixed gas as a material gas of $CH_4$ and $H_2$ mixed at a percentage of $CH_4 / H_2 = 1/100$ was introduced into the reaction container where pressure was held at (25 Torr) $33.3 \times 10^2 Pa$ at a rate of 500 ml/min. A W-filament was used as a thermal electron radiating material, which was heated to 2,000 °C and, by using the external heating oven, the surfaces of the substrates were heated to 900 °C and an RF power supply of 13.56 MHz. was used to load the space for forming plasma with RF at a power flux density of 0.08 $W/cm^3$. A diamond film about 6 $\mu$m thick was formed on each substrate through a 4-hour coating process. The substrate is referred to as A. For comparison, another case was attempted wherein substrates were not provided with RF. With no RF, the substrates were processed under the same coating conditions excluding the provision of the RF submitted to the 5-hour coating process, whereby a diamond film 6 $\mu$m thick was obtained likewise. The latter substrate is referred to as B. The Raman spectroscopic analysis was made to physically evaluate the diamond films formed on the substrate A and B. A sharp Raman peak of 1,333 $cm^{-1}$ attributable to diamond and a broad peak in proximity to 1,550 $cm^{-1}$ ascribed to carbon other than that of diamond were seen on substrate B, whereas only the sharp Raman peak of 1,333 $cm^{-1}$ was observed on substrate A and no broad peak existed. When micro structure was observed using a scanning microscope, a number of twins were observed on substrate B whereas defects such as a twin were scarcely found on substrate A. In other words, there was obtained a crystalline diamond film with almost nearly no allotropes of carbon other than diamond and substantially free from defects such as twin.

Cutting tests were further made for the substrates A, B and a substrate C which had not been submitted to the coating process.

Material being cut: AC 4 C

Cutting speed: 1,200 m/min

Feed: 0.1 mm/rev.

Depth of cut: 1.0 mm

Holder: FP 11R-44A

For A, flank wear was 0.02 mm after cutting for 45 minutes, whereas the diamond film was peeled off after cutting for 15 minutes for B. In the case of substrate C without the diamond coating, the flank wear was 0.50 mm for 2 minutes.

Example 2

Substrates prepared from ISO K-10 extra-hard alloy No. SPG 422, available on the open market, were submitted to diamond coating using the apparatus of Figs. 1a and 1b. The reaction container was made of alloy and did not have an external electrode 5. There was made an arrangement of 30 bases concentrically in one tier and vertically 20 tiers, i.e., 600 pieces/batch with rake faces directed to the thermal electron radiating material for the coating process. The coating conditions include a mixed gas as a material gas of $CH_4$ and $H_2$ mixed at a percentage of $CH_4/H_2$ = 1/100 was introduced into the reaction container where pressure was held at (20 Torr) 26.6 x $10^2$ Pa at a rate of 1000 ml/min. A W-filament was used as a thermal electron radiating material, which was heated to 2,000°C and, by using the external heating oven, the surfaces of the rake faces were heated to 930°C and the RF power supply of 13.56 MHz. was used to load the space for forming plasma with RF at a power flux density of 0.08 W/cm³. Against a target film thickness of 6 μm on the rake faces of TA in the same tier, variation in the thickness was less than 5% and that in 20 vertical tiers was less than 10% after the 4-hour coating process.

The value obtained according to the present invention were not inferior to those obtained by the conventional CVD coating apparatus for industrial use in terms of film quality and the small quantity batch. Thus, it was confirmed that a large number of substrates could be uniformly coated.

Since the coating apparatus used during the tests was small, processing quantity may readily be increased. As in example of the substrate having a large area to be processed, an Mo base 150 (W) x 300 (L) x 30 (T) mm was coated with diamond. The above coating apparatus with a replaced substrate support jig was used to set the substrates.

The coating conditions here those described above but the surface temperature was set at 900°C. After a 6.5-hour coating process, a diamond film 10 μm thick on the average was obtained on each face directed to the thermal electron radiating material with less than 10% variation in the film thickness. This established that even large-sized substrates can uniformly be coated with diamond.

Example 3

A small diameter drill (0.8 mm in diameter) of super fine extra-hard alloy, an article on the market, was coated with diamond using the apparatus of Figs. 2a and 2b. The interior of the reaction container was vacuumized to ($10^{-3}$ Torr) 0.133 Pa first and a mixed gas of $CH_4$ and $H_2$ as a material gas mixed at a percentage of $CH_4/H_2$ = 0.5/100 was introduced into the reaction container at a rate of 300 ml/min, whereas pressure in the reaction container was held at (40 Torr) 53.2 x $10^2$ Pa. The W-filament was used as a thermal electron radiating material and heated to 2,050°C and, by adjusting the external oven, the surface temperature was set at 880°C. The RF power supply of 13.56 MHz. was further used to load the space for forming plasma with RF at a power flux density of 0.07 w/cm³. The substrate was caused to rotate and revolve by the substrate rotating mechanism. After the 2.5-hour coating process, a diamond film about 3 μm thick was uniformly formed. This substrate is referred to as D.

Substrate D and a substrate H which had not be submitted to the coating process were used to make cutting tests under the following conditions.

Material being cut: Quartz fiber cloth substrate

Number of revolutions of the drill: 60,000 rpm

Feed: f = 0.05 mm/rev

For substrate D, the width of the worn relief face at the tip of the blade after 150,000 hits was 0.07 mm, whereas the substrate E became not usable after about 6,000 hits.

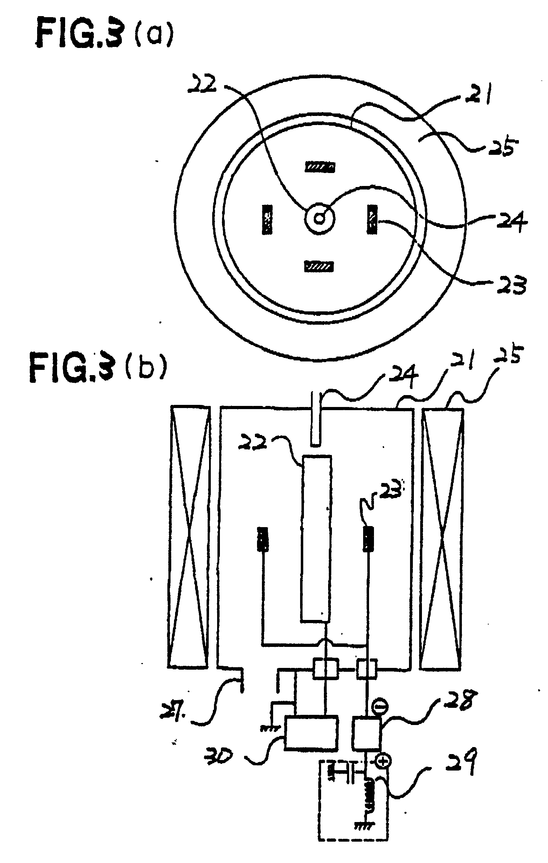

Figs. 3a and 3b shows another preferred embodiment of an apparatus for manufacturing diamonds. High-frequency plasma is generated between a reaction container (conductor) 21 and a thermal electron radiating material 22 (driven by a power supply 30) inside the reaction container 21 and substrates 23 are provided by a d.c. power supply 28 with a d.c. bias. In order to protect the d.c. power supply, a high-frequency cut-off filter 29 is employed. The surfaces of the substrates 23 are heated to higher than 600°C and lower than 1,200°C by the thermal electron radiating material 22 heated to higher than 1,600°C, an external heater 25 and the ion bombardment effect by the high-frequency plasma.

The air inside the reaction container 21 is exhausted from an exhaust port 27 fitted to the reaction container 21 and vacuumized by a vacuumizer and the pressure is kept at higher than (0.1 Torr) 0.133 x 10 Pa and lower than (100 Torr) 133 x $10^2$ Pa.

A mixed gas of hydrogen and hydrocarbon is supplied to thermal electron radiating material 22 through a material gas supply port 24, decomposed and excited by the high-frequency plasma generated by the thermal electron radiating material 22 and between the thermal electron radiating material 22 and reaction container 21. The mixed gas is maintained in the activated state, whereby diamond is deposited on the surfaces of the substrates where the absolute value of the d.c. bias is held at lower than 1,000 V.

The following examples utilize the Figs. 3a and 3b apparatus.

Example

Substrates prepared from ISO K-10 extra-hard alloy No. SPG 422, available on the open market, were submitted to diamond coating using the apparatus of Figs. 3a and 3b.

The interior of the reaction container was first vacuumized to lower than $(10^{-3}$ Torr) 0.133 Pa and a mixed gas as a material gas of $CH_4$ and $H_2$ mixed at a percentage of $CH_4/H_2 = 1/100$ was introduced into the reaction container where pressure was held at (30 Torr) $39.9 \times 10^2$ at a rate of 500 ml/min. A W-filament was used as a thermal electron radiating material, which was heated to $2,000°C$ and, by adjusting the external testing oven, the surfaces of the substrates were heated to $930°C$ and an RF power supply of 13.56 MHz. was used to load the space for forming plasma with RF at a power flux density of 0.6 $W/cm^3$. A d.c. power supply was further used to hold the substrates at -400 V. A diamond film about 6 $\mu m$ was formed on each substrate through a 4-hour coating process. The substrate is referred to as J. For comparing purposes, another case was attempted wherein substrates were not provided by the d.c. power supply with the negative potential. At that time, the latter substrates were processed under the same coating conditions excluding the provision of the negative potential and submitted to the 4-hour coating process, whereby a diamond film 6 $\mu m$ thick was obtained likewise. The latter substrate is referred to as K. The Raman spectroscopic analysis was made to physically evaluate the diamond films formed on the substrates J, K. A sharp Raman peak of 1,333 $cm^{-1}$ attributable to diamond and a broad peak in proximity to 1,550 $cm^{-1}$ ascribed to carbon other than that of diamond were seen on the substrate K, whereas only the sharp Raman peak of 1,333 $cm^{-1}$ was observed on the substrate J and no broad peak existed. When micro structure was observed using a scanning microscope, a number of twins were observed on the substrate K, whereas defects such as twin were scarcely found on the substrate J. Thus, there was obtained a crystalline diamond film with almost nearly no allotropes of carbon other than diamond and substantially free from defects such as a twin.

With respect to the micro structure, J was structurally finer than K. The evaluation of adhesion strength by means of a scratch tester revealed that the value for J was about 50% greater than that for K. Cutting tests were further made for the substrates J, K and a substrate L which had not been submitted to the coating process.

Material being cut: /al - 25% Si alloy
Cutting speed: 500 ml/min
Feed: 0.1 mm/rev
Depth of cut: 0.5 mm
Holder: FP 11R-44A

For J, flank wear was 0.06 mm after cutting for 20 min, whereas 0.10 mm for K. In the case of substrate L without the diamond coating, the flank wear was 0.42 mm for 30 seconds.

It was thus proved that the provision of the negative potential for the substrate by means of the d.c. power supply improved cutting performance effectively.

Example 5

A tungsten (W) substrate of 10mm X 10mm X 5mm was coated with diamond using the apparatus of Figs. 3a and 3b. The substrate grinded by a diamond grindstone having a diameter of 220mm was used.

The interior of the reaction container was first exhausted to lower than $(10^{-3}$ Torr) 0.133 Pa and then it was preheated by the external heating oven. Thereafter, a mixed gas as a material gas of $CH_4$ and $H_2$ mixed at a percentage of $CH_4/H_2 = 2/100$ was introduced into the reaction container where pressure was held at (30 torr) $39.9 \times 10^2$ Pa at a rate of 500 ml/min. A Ta filament was used as a thermal electron radiating material, which was carbonized in advance into TaC and was heated to $2,150°C$. An RF power supply of 13.56 MHz was used to load the space for forming plasma with RF at a power flux density of 0.08 $W/cm^3$. A d.c. power supply was further used to hold the substrate at 300v. The temparature of the substrate after the generation of plasma was $970°C$. A diamond film about 8 $\mu m$ was formed on the substrate through a 2-hour coating process. The substrate is referred to as L. For comparing purposes, another case was attempted wherein a substrate was not provided by the d.c. power supply with the positive bias. The latter substrate was heated to $970°C$ by adjusting the external heating oven and submitted to the 4-hour coating process, whereby a diamond film of 8 $\mu m$ thick was obtained. The latter substrate is referred to as M. The Raman spectroscopic analysis was made to physically evaluate the diamond films formed on the substrates L and M. A sharp Raman peak of 1,333cm$^{-1}$ ascribed to diamond and a broad peak in proximity to 1,550cm$^{-1}$ ascribed to carbon other than diamond were seen on the substrate M, whereas only the sharp Raman peak of 1,333cm$^{-1}$ was observed on the substrate L. When micro structure was observed using a scanning microscope, detects such as a twin were scarcely observed on the substrate L, whereas a number of defects were observed on the substrate M. Thus, there was obtained a crystalline diamond film with almost nearly no allotropes of carbon other than diamond, such as an amorphous carbon or the like, by applying the positive bias to the substrate, and the rate of vacuum evaporation was increased.

## Claims

1. A low pressure gas-phase diamond synthesizing process, comprising the steps of:

   heating a substrate disposed in a reaction container to higher than 600°C and lower than 1,200° C;

   activating a mixed gas of hydrogen and hydrocarbon using a thermal electron radiating material heated to higher than 1,600° C, in which gas the percentage of the number of carbon atoms contained in the hydrocarbon in terms of H$_2$ is more than 0.01 and less than 20 and in which reaction container the pressure is 0.133 x 10$^2$ to 133 x 10$^2$ Pa (0.1 to 100 Torr.);

   forming high-frequency plasma by providing capacitive coupling-type feeding to the thermal electron radiating material using a high-frequency power supply so as to employ activation implemented by the thermal electron radiating material and that which is effected by the formation of the high-frequency plasma; and

   depositing diamond on surfaces of said substrate; wherein

   the step of forming a high frequency plasma comprises the step of forming a plasma by providing capacitive coupling-type feeding between said thermal electron radiating material and an electrode within said reaction container, or

the step of forming a plasma by providing capacitive coupling-type feeding between said thermal electron radiating material and said reaction container which is conductive, or

the step of forming a plasma by providing capacitive coupling-type feeding between said thermal electron radiating material and an electrode external to said reaction container.

2. A process according to Claim 1, further comprising the step of rotating said substrate during deposition of the diamond material.

3. A process according to Claim 1, further comprising the step of providing said substrate with a d.c. bias using a d.c. power supply and of providing a high-frequency cut-off filter inserted between the high-frequency and the d. c. power supply, wherein the d. c. potential provided to the substrate is less than 1 ,000 V.

## Revendications

1. Un procédé de synthèse du diamant en phase gazeuse à basse pression comprenant les étapes suivantes:

   - chauffage d'un substrat disposé dans un récipient de réaction à une température supérieure à 600° C et inférieure à 1 200° C ;

   - activation d'un mélange gazeux d'hydrogène et d'hydrocarbure utilisant un matériau à rayonnement électronique thermique chauffé à une température supérieure à 1 600°C, dans ledit gaz 1e pourcentage du nombre d'atomes de carbone contenu dans l'hydrocarbure en terme de H$_2$ étant supérieur à 0,01 et inférieur a 20 et dans ledit récipient de réaction la pression étant de 0,133 X 10$^2$ à 133 x 10$^2$ pa (0,1 à 100 torr);

   - formation d'un plasma haute fréquence en fournissant une alimentation du type à couplage capacitif au matériau à rayonnement électronique thermique utilisant une source de courant haute fréquence afin d'employer l'activation fournie par le matériau à rayonnement életronique thermique et celle qui est effectuée par la formation du plasma haute fréquence ; et

   - dépôt du diamant sur les surfaces dudit substrat ; procédé selon lequel

   l'étape de formation d'un plasma haute fréquence comprend l'étape de formation d'un plasma en fournissant une alimentation du type à couplage capacitif entre ledit matériau à rayonnement électronique thermique et une électrode à l'intérieur dudit récipient de réaction, ou bien

l'étape de formation d'un plasma en fournissant une alimentation du type à couplage capacitif entre ledit matériau à rayonnement électronique thermique et ledit récipient de réaction qui est conducteur, ou bien

l'étape de formation d'un plasma en fournissant une alimentation du type à couplage capacitif entre ledit matériau à rayonnement électronique thermique et une électrode extérieure audit récipient de réaction.

2. Un procédé selon la revendication 1, comprenant également l'étape d'entraînement en rotation dudit substrat durant le dépôt du diamant.

3. Un procédé selon la revendication 1, comprenant également l'étape de fourniture audit substrat d'une polarisation en courant continu utilisant une source de courant continu et de fourniture d'un filtre de coupure à haute fréquence inséré entre la source de haute fréquence et la source de courant continu, selon lequel la tension en courant continu fournie au substrat est inférieure à 1 000V.

## Ansprüche

1. Ein Niederdruckgasphasen-Diamantensyntheseprozess, mit den Verfahrensschritten:

Aufheizen eines in einem Reaktionscontainer angeordneten Substrats auf mehr als 600 °C und weniger als 1200 °C;

Aktivieren eines gemischten Gases aus Wasserstoff und einer Kohlenwasserstoffverbindung unter Verwendung eines thermische Elektronen ausstrahlenden Materials, das auf mehr als 1600 °C aufgeheizt wird, wobei in dem Gas der Prozentsatz der Zahl der Kohlenstoffatome, die in der Kohlenwasserstoffverbindung in Gliedern von $H^2$ enthalten sind, größer als 0,01 und kleiner als 20 ist, und wobei der Druck in dem Reaktionscontainer $0,133 \times 10^2$ bis $133 \times 10^2$ Pa (0,1 bis 100 Torr) beträgt;

Bilden eines Hochfrequenzpasmas durch Vorsehen einer Speisung für das thermische Elektronen aussendende Material in Art einer kapazitiven Kopplung, unter Vervendung einer Hochfrequenzspannungsversorgungseinrichtung, um so eine Aktivierung anzuwenden, die durch das thermische Elektronen aussendende Material und das, was durch die Bildung des Hochfrequenzplasma bewirkt wird, verwirklicht wird; und

Deponieren eines Diamanten auf der Oberfläche des Substrats; wobei

der Schritt der Bildung des Kochfrequenzplasmas den Verfabrensschritt der Bildung eines Plasmas durch Vorsehen einer Speisung in der Art einer kapazitiven Kopplung zwischen dem thermische Elektronen aussendenen Material und einer Elektrode innerhalb des Reaktionscontainers, oder

den Verfahrensschritt der Bildung des Plasmas durch Vorsehen einer Speisung in der Art einer kapazitiven Kopplung zwischen den thermische Elektronen aussendenden Material und dem Reaktioncontainer, welcher leitend ist, oder

den Schritt der Bildung eines Plasmas durch Vorsehen einer Speisung in der Art einer Kapazitiven Kopplung zwischen dem thermische Elektronen aussendenden Material und einer Elektrode außerhalb des Reaktionscontainers umfaßt.

2. Ein Verfahren nach Anspruch 1, das weiterhin den Verfahrensschritt der Drehung des Substrats während der Deponierung des Diamentenmaterials umfaßt.

3. Ein Verfahren nach Anspruch 1 , das weiterhin den Verfahrensschritt der Vorsorgung des Substrats mit einer Gleichspannung unter Verwendung einer Gleichspannungsversorgungseinrichtung und das Vorsehen eines Hochfrequenzsperrfilters, das zwischen der Hochfrequenz- und der Gleichspannungsversorgungseinrichtung eingefügt wird, wobei das an das Substrat angelegte Gleichspannungspotential kleiner als 1000 V ist.

FIG. 1 (a)

FIG. 2 (a)

FIG. 1 (b)

FIG. 2 (b)

EP 0 230 927 B1

## FIG.3 (a)

## FIG.3 (b)